# EUROPÄISCHE PATENTSCHRIFT

(11) **EP 0 291 779 B1**
(45) Veröffentlichungstag und Bekanntmachung des Hinweises auf die Patenterteilung: **27.07.1994**
(21) Anmeldenummer: 88107255.7
(22) Anmeldetag: 05.05.1988
(51) Int. Cl.: G03F 7/023

(54) **Wärmebeständige Positivresists und Verfahren zur Herstellung wärmebeständiger Reliefstrukturen**
Heat-resistant positive resist, and process for the production of heat-resistant resist patterns
Réserves positives résistantes à la chaleur et procédé de fabrication de structures formant réserve résistantes à la chaleur

(30) Priorität: 18.05.1987 DE 3716627
(43) Veröffentlichungstag der Anmeldung: 23.11.1988
(73) Patentinhaber: SIEMENS AKTIENGESELLSCHAFT, 80333 München (DE)
(72) Erfinder: Ahne, Hellmut, Dr., D-8551 Röttenbach (DE); Hammerschmidt, Albert, Dr., D-8520 Erlangen (DE)

(56) Entgegenhaltungen:
- EP-A- 0 023 662
- EP-A- 0 264 678
- FR-A- 2 317 680

## Beschreibung

Die Erfindung betrifft wärmebeständige Positivresists auf der Basis von oligomeren und/oder polymeren Polybenzoxazol-Vorstufen und Diazochinonen sowie ein Verfahren zur Herstellung wärmebeständiger Reliefstrukturen aus derartigen Positivresists.

Wärme- bzw. hochwärmebeständige Photoresists werden insbesondere für die kostengünstige direkte Erzeugung strukturierter Isolierschichten benötigt. Die Resistmaterialien bzw. die entsprechenden Reliefstrukturen dürfen sich bei den dabei angewandten hohen Temperaturen nicht zersetzen. Die Reliefstrukturen dürfen sich ferner nicht verformen, wie es beim Erweichen oder Fließen des Polymermaterials geschehen kann, sie müssen vielmehr formstabil sein.

Herkömmliche Positivresists, beispielsweise auf der Basis von Novolaken, sind für einen Hochtemperatureinsatz ungeeignet, da sie dabei erweichen und die Polymerkette abgebaut wird. Hochtemperaturbeständige Negativresists andererseits, wie sie beispielsweise aus den deutschen Patentschriften 23 08 830 und 24 37 348 bekannt sind, unterliegen den Nachteilen, die negativ arbeitenden Photolacken eigen sind, nämlich: negative Flanken, relativ lange Belichtungszeiten, relativ geringes Auflösungsvermögen und das Erfordernis der Verwendung ökologisch ungünstiger Entwickler.

Aus der DE-OS 26 31 535 ist ein wärmebeständiger Positivresist auf der Basis Polyamidocarbonsäure/Diazochinon bekannt. Dieser Positivresist weist aber eine Reihe von Nachteilen auf, wie begrenzte Lagerfähigkeit, ungenügende Stabilität gegenüber alkalischen Ätzlösungen und geringen Löslichkeitsunterschied zwischen belichteten und unbelichteten Stellen.

Die vorstehend genannten ungenügenden Eigenschaften treten dann nicht mehr auf, wenn Positivresists auf der Basis von oligomeren und/oder polymeren Vorstufen von Polyoxazolen und Diazochinonen verwendet werden (siehe EP-PS 0 023 662). Die Polyoxazol-Vorstufen sind dabei Polykondensationsprodukte aus aromatischen und/oder heterocyclischen Diaminodihydroxyverbindungen und Dicarbonsäurechloriden oder -estern. Bevorzugt werden Vorstufen von Polybenzoxazolen eingesetzt.

Aufgabe der Erfindung ist es, das Angebot an kostengünstigen hochwärmebeständigen Positivresists auf der Basis von Polybenzoxazol-Vorstufen und Diazochinonen zu erweitern, wobei vor allem auch Positivresists mit einem neuen Eigenschaftsspektrum, insbesondere mit einem hohen Auflösungsvermögen, geschaffen werden sollen.

Dies wird erfindungsgemäß dadurch erreicht, daß die Polybenzoxazol-Vorstufen Hydroxypolyamide in Form von Polykondensationsprodukten sind, aufgebaut aus:
- 3,3'-Dihydroxybenzidin oder 3,3'-Dihydroxy-4,4'-diaminodiphenylether,
- 2,2-Bis(3-amino-4-hydroxyphenyl)-1,1,1,3,3,3-hexafluorpropan und
- Isophthalsäuredichlorid, Isophthalsäure, Terephthalsäuredichlorid oder Terephthalsäure.

Die Hydroxypolyamide der vorstehend genannten Art sind Polykondensationsprodukte, und zwar Co-Polykondensationsprodukte aus aromatischen Diaminodihydroxyverbindungen und aromatischen Dicarbonsäuren bzw. Dicarbonsäurechloriden. Zum Aufbau der Co-Polykondensationsprodukte dienen dabei stets zwei verschiedene Diaminodihydroxyverbindungen.

Die erfindungsgemäßen Positivresists zeigen ein hervorragendes Auflösungsvermögen. Ferner sind die in diesen Positivresists enthaltenen Hydroxypolyamide präparativ einfach und kostengünstig herstellbar. Durch die Verwendung verschiedenartiger Diaminodihydroxyverbindungen in ein- und derselben Polymer-Vorstufe kann darüber hinaus ein spezielles Eigenschaftsspektrum erzeugt werden, insbesondere eine niedrige Feuchteaufnahme und eine gute Löslichkeit.

Als photoreaktive Additive gelangen in den erfindungsgemäßen Positivresists an sich bekannte lichtempfindliche Diazochinone zum Einsatz, insbesondere o-Chinon- und o-Naphthochinondiazide (siehe dazu EP-PS 0 023 662). Vorzugsweise werden Ester oder Amide der 6-Diazo-5(6)-oxo-1-naphthalinsulfonsäure verwendet, insbesondere der Bis-naphthochinon-[1,2]-diazid-(2)-5-sulfonsäureester von β,β-Bis(4-hydroxyphenyl)-propan. Das Gewichtsverhältnis von Hydroxypolyamid zu Diazochinon liegt dabei vorteilhaft zwischen 1:20 und 20:1, vorzugsweise zwischen 1:10 und 10:1.

Zur Herstellung wärmebeständiger Reliefstrukturen wird ein erfindungsgemäßer Positivresist in Form einer Schicht oder Folie auf ein Substrat aufgebracht und mit aktinischem Licht durch eine Maske belichtet oder durch Führen eines Licht-, Elektronen- oder Ionenstrahls bestrahlt. Anschließend werden die belichteten bzw. bestrahlten Schicht- oder Folienteile herausgelöst oder abgezogen, und die dabei erhaltenen Reliefstrukturen werden dann getempert.

Der Photoresist kann vorteilhaft in einem organischen Lösungsmittel gelöst auf das Substrat aufgebracht werden. Als Lösungsmittel wird dabei vorzugsweise N-Methylpyrrolidon verwendet. Daneben können aber auch andere organische Lösungsmittel mit ähnlichen Eigenschaften zum Einsatz gelangen, wie Dimethylformamid und N,N-Dimethylacetamid, sowie Gemische der genannten Lösungsmittel.

Die Lösung, der vorteilhaft Zusätze zur Verbesserung der Haftung und/oder der Benetzung zugegeben werden können, wird vorzugsweise mittels der Schleudertechnik auf das Substrat aufgebracht. Daneben können aber auch andere Beschichtungsmethoden, wie Tauchen, Sprühen, Bürsten oder Rollen, angewendet werden. Im übrigen können Haftvermittler bzw. Benetzungsmittel auch - vor dem Aufbringen der Lösung - direkt auf das Substrat aufgebracht werden. Das Substrat selbst ist vorzugsweise aus Glas, aus Metall, insbesondere Aluminium, aus Kunststoff oder aus halbleitendem Material.

Die Konzentration der Resistlösung wird so eingestellt, daß Schichtstärken von 0,01 µm bis einige 100 µm erzeugt werden können. Es hat sich gezeigt, daß beispielsweise beim Schleuderbeschichten 300 bis 10 000 U/min für die Dauer von 1 bis 100 s geeignet sind, um eine gleichmäßige und gute Oberflächenqualität zu erzielen.

Nach dem Aufbringen der Lösung auf das Substrat wird das Lösungsmittel entfernt, d.h. es wird getrocknet. Dies kann bei Raumtemperatur oder bei erhöhter Temperatur erfolgen; vorzugsweise wird das Lösungsmittel bei einer Temperatur zwischen 50 und 120°C entfernt. Bei der Entfernung des Lösungsmittels kann im übrigen auch im Vakuum gearbeitet werden.

Zur Erzielung eines ausreichenden Löslichkeitsunterschiedes zwischen den bestrahlten und den nicht bestrahlten Schicht- bzw. Folienteilen genügen bei den erfindungsgemäßen Positivresists - bei der Verwendung einer Quecksilberdampfhöchstdrucklampe - in Abhängigkeit von der verwendeten Resistzusammensetzung und der Schichtstärke Belichtungszeiten zwischen 1 und 600 s. Nach dem Belichten werden die belichteten Teile der Schicht bzw. Folie mit einem wäßrig-alkalischen Entwickler herausgelöst.

Mittels der erfindungsgemäßen Positivresists werden konturenscharfe Bilder, d.h. Reliefstrukturen, erhalten, die durch Tempern in hochwärmebeständige Polybenzoxazole umgewandelt werden. Im allgemeinen werden dabei Temperaturen zwischen 200 und 500°C gewählt. Vorzugsweise erfolgt die Temperung bei einer Temperatur zwischen 300 und 400°C. Der Temperprozeß selbst wird im allgemeinen innerhalb eines Zeitraums von 0,1 bis 8 h durchgeführt, vorzugsweise innerhalb von 1 bis 4 h.

Die nach dem erfindungsgemäßen Verfahren hergestellten Reliefstrukturen können zur Herstellung von Passivierungsschichten auf Halbleiterbauelementen, von Dünn- und Dickfilmschaltungen, von Lötschutzschichten auf Mehrlagenschaltungen, von Isolierschichten als Bestandteil von Schichtschaltungen und von miniaturisierten Isolierschichten auf elektrisch leitenden und/oder halbleitenden und/oder isolierenden Basismaterialien, insbesondere im Bereich der Mikroelektronik oder allgemein für die Feinstrukturierung von Substraten, Anwendung finden. Vorzugsweise dienen die hochwärmebeständigen Reliefstrukturen als Masken für Naß- und Trockenätzprozesse, stromlose oder galvanische Metallabscheidung und Aufdampfverfahren sowie als Masken für die Ionenimplantation, darüber hinaus als Isolier- und Schutzschichten in der Elektrotechnik. Diese Reliefstrukturen können ferner vorteilhaft als Orientierungsschichten, beispielsweise in Flüssigkristalldisplays, sowie zur Rasterung von Oberflächen, beispielsweise bei Röntgenschirmen, insbesondere Röntgenbildverstärkern, verwendet werden.

Anhand von Ausführungsbeispielen soll die Erfindung noch näher erläutert werden.

### Beispiel 1

### Darstellung einer Polymer-Vorstufe

60 Gewichtsteile 2,2-Bis(3-amino-4-hydroxyphenyl)-1,1,1,3,3,3-hexafluorpropan und 34,4 Gewichtsteile 3,3'-Dihydroxybenzidin werden in 650 Gewichtsteilen N,N-Dimethylacetamid gelöst. Nach Hinzufügen von 140 Gewichtsteilen Pyridin werden zur Lösung bei 0°C unter starkem Rühren 59,5 Gewichtsteile Isophthalsäuredichlorid, gelöst in 265 Gewichtsteilen Cyclohexanon, innerhalb von 2 h getropft. Die viskose Lösung wird anschließend noch 1 h bei 0°C gerührt und dann 12 h bei Raumtemperatur stehengelassen. Anschließend wird die Lösung unter starkem Rühren in 10 000 Gewichtsteile destilliertes Wasser getropft. Das dabei ausfallende Harz wird abgesaugt, im Vakuum getrocknet und mit Methanol gewaschen.

### Beispiel 2

### Herstellung einer Reliefstruktur

Eine Resistlösung, bestehend aus 3 Gewichtsteilen des nach Beispiel 1 hergestellten Polymer und 0,6 Gewichtsteilen Bis-naphthochinon-[1,2]-diazid-(2)-5-sulfonsäureester von β,β-Bis(4-hydroxyphenyl)-propan als photoreaktive Komponente, gelöst in 13 Gewichtsteilen N-Methylpyrrolidon, wird durch ein 0,8 µm-Filter druckfiltriert. Die fertige Lösung wird dann bei 3000 U/min auf einen mit einem Haftvermittler versehenen Siliciumwafer aufgeschleudert und 15 min bei 80°C getrocknet (Schichtdicke: 1,6 µm). Der beschichtete Siliciumwafer wird mittels einer 350 W-Quecksilberdampfhöchstdrucklampe (Leistung: 23 mW/cm²) 6 bis 7 s kontaktbelichtet, 35 s entwickelt (Entwickler: Shipley Microposit 303, im Verhältnis 1:40 mit Wasser verdünnt) und bei 400°C getempert. Dabei werden feine hochwärmebeständige Strukturen erhalten (< 1,6 µm).

Das getemperte Polymer weist folgende Eigenschaften auf (r.F. = relative Feuchte):
Dielektrizitätskonstante ε 25°C, 0 % r.F. = 2,9;
Verlustwinkel tan δ 25°C, 0 % r.F. = 3,9 . 10⁻³;
Feuchteaufnahme 0 % → 100 % r.F. = 2,2 % (bei 25°C).

## Patentansprüche

1. Wärmebeständige Positivresists auf der Basis von oligomeren und/oder polymeren Polybenzoxazol-Vorstufen und Diazochinonen, **dadurch gekennzeichnet,** daß die Polybenzoxazol-Vorstufen Hydroxypolyamide in Form von Polykondensationsprodukten sind, aufgebaut aus:
- 3,3'-Dihydroxybenzidin oder 3,3'-Dihydroxy-4,4'-diaminodiphenylether,
- 2,2-Bis(3-amino-4-hydroxyphenyl)-1,1,1,3,3,3-hexafluorpropan und
- Isophthalsäuredichlorid, Isophthalsäure, Terephthalsäuredichlorid oder Terephthalsäure.

2. Positivresists nach Anspruch 1, **dadurch gekennzeichnet,** daß die Hydroxypolyamide Polykondensationsprodukte aus 3,3'-Dihydroxybenzidin, 2,2-Bis(3-amino-4-hydroxyphenyl)-1,1,1,3,3,3-hexafluorpropan und Isophthalsäuredichlorid sind.

3. Positivresists nach Anspruch 1 oder 2, **dadurch gekennzeichnet,** daß das Diazochinon ein Ester oder ein Amid der 6-Diazo-5(6)-oxo-1-naphthalinsulfonsäure ist.

4. Positivresists nach einem der Ansprüche 1 bis 3, **dadurch gekennzeichnet,** daß das Gewichtsverhältnis von Hydroxypolyamid zu Diazochinon zwischen 1:20 und 20:1, vorzugsweise zwischen 1:10 und 10:1, liegt.

5. Verfahren zur Herstellung wärmebeständiger Reliefstrukturen, **dadurch gekennzeichnet,** daß ein Positivresist nach einem oder mehreren der Ansprüche 1 bis 4 in Form einer Schicht oder Folie auf ein Substrat aufgebracht und mit aktinischem Licht durch eine Maske belichtet oder durch Führen eines Licht-, Elektronen- oder Ionenstrahls bestrahlt wird, daß die belichteten bzw. bestrahlten Schicht- oder Folienteile herausgelöst oder abgezogen und die dabei erhaltenen Reliefstrukturen getempert werden.

6. Verfahren nach Anspruch 5, **dadurch gekennzeichnet,** daß der Positivresist in einem organischen Lösungsmittel gelöst auf das Substrat aufgebracht wird.

7. Verfahren nach Anspruch 6, **dadurch gekennzeichnet,** daß als Lösungsmittel N-Methylpyrrolidon verwendet wird.

8. Verfahren nach einem der Ansprüche 5 bis 7, **dadurch gekennzeichnet,** daß der Lösung ein Haftvermittler und/oder ein Benetzungsmittel zugegeben wird.

9. Verfahren nach einem oder mehreren der Ansprüche 5 bis 8, **dadurch gekennzeichnet,** daß die Lösung mittels Schleudertechnik auf das Substrat aufgebracht wird.

10. Verfahren nach einem oder mehreren der Ansprüche 5 bis 9, **dadurch gekennzeichnet,** daß ein Substrat aus Glas, Metall, insbesondere Aluminium, Kunststoff oder halbleitendem Material verwendet wird.

11. Verfahren nach einem oder mehreren der Ansprüche 5 bis 10, **dadurch gekennzeichnet,** daß die Reliefstrukturen bei einer Temperatur zwischen 200 und 500°C, vorzugsweise zwischen 300 und 400°C, getempert werden.

## Claims

1. Heat-resistant positive resist based on oligomeric and/or polymeric polybenzoxazole precursors and diazoquinones, characterized in that the polybenzoxazole precursors are hydroxypolyamides in the form of polycondensation products, constituted from:
- 3,3'-dihydroxybenzidine or 3,3'-dihydroxy-4,4'-diaminodiphenylether,
- 2,2-bis(3-amino-4-hydroxyphenyl)-1,1,1,3,3,3-hexafluoropropane and
- isophthalic acid dichloride, isophthalic acid, terephthalic acid dichloride or terephthalic acid.

2. Positive resist according to claim 1, characterized in that the hydroxypolyamides are polycondensation products consisting of 3,3'-dihydroxybenzidine, 2,2-bis(3-amino-4-hydroxyphenyl)-1,1,1,3,3,3-hexafluoropropane and isophthalic acid dichloride.

3. Positive resist according to claim 1 or 2, characterized in that the diazoquinone is an ester or an amide of the 6-diazo-5(6)-oxo-1-naphthalenesulfonic acid.

4. Positive resist according to one of claims 1 to 3, characterized in that the weight ratio of hydroxypolyamide to diazoquinone lies between 1:20 and 20:1, preferably between 1:10 and 10:1.

5. Method for producing heat-resistant relief structures, characterized in that a positive resist according to one or more of claims 1 to 4 is applied in the form of a layer or film to a substrate and is illuminated with actinic light through a mask or is irradiated by the guiding of a light beam, electron beam or ion beam, in that the illuminated or irradiated layer or film parts are released or pulled off and the relief structures obtained in this way are tempered.

6. Method according to claim 5, characterized in that the positive resist, dissolved in an organic solvent, is applied to the substrate.

7. Method according to claim 6, characterized in that N-methyl pyrrolidone is used as solvent.

8. Method according to one of claims 5 to 7, characterized in that an adhesion promoter and/or a wetting agent is added to the solution.

9. Method according to one or more of claims 5 to 8, characterized in that the solution is applied to the substrate by means of a centrifugal technique.

10. Method according to one or more of claims 5 to 9, characterized in that a substrate consisting of glass, metal, in particular aluminium, plastics or semi-conducting material is used.

11. Method according to one or more of claims 5 to 10, characterized in that the relief structures are tempered at a temperature between 200 and 500°C, preferably between 300 and 400°C.

## Revendications

1. Réserve positive résistant à la chaleur à base de précurseurs oligomères et/ou polymères de polybenzoxazole et, de diazoquinones, caractérisée en ce que les précurseurs de polybenzoxazole sont des hydroxypolyamides sous forme de produits de polycondensation constitués par:
- la 3,3'-dihydroxybenzidine ou l'éther 3,3'-dihydroxy-4,4' diaminodiphénylique,
- le 2,2-bis-(3-amino-4-hydroxyphényl)-1,1,1,3,3,3-hexa-fluoropropane et
- le dichlorure de l'acide isophtalique, l'acide isophtalique, le dichlorure de l'acide téréphtalique ou l'acide téréphtalique.

2. Réserve positive selon la revendication 1, caractérisée en ce que les hydroxypolyamides sont des produits de polycondensation de la 3,3'-dihydroxybenzidine, du 2,2-bis-(3-amino-4-hydroxyphényl)-1,1,1,3,3,3-hexafluoropropane et du dichlorure de l'acide isophtalique.

3. Réserve positive selon la revendication 1 ou 2, caractérisée en ce que la diazoquinone est un ester ou un amide de l'acide 6-diazo-5(6)-oxo-1-naphtalènesulfonique.

4. Réserve positive selon l'une quelconque des revendications 1 à 3, caractérisée en ce que le rapport pondéral hydroxypolyamine:diazoquinone se situe entre 1:20 et 20:1, de préférence entre 1:10 et 10:1.

5. Procédé pour la préparation de structures en relief résistant à la chaleur, caractérisé en ce qu'on applique une réserve positive, selon l'une ou plusieurs des revendications 1 à 4, sur un substrat sous la forme d'une couche ou d'une feuille et on l'expose à travers un masque avec de la lumière actinique ou on l'irradie en dirigeant un rayon lumineux, un rayon électronique ou un rayon ionique, en ce que les parties de couche ou de feuille exposées à la lumière ou irradiées des rayons sont éliminées par dissolution ou pelées et les structures à relief obtenues en l'occurrence sont soumises à un traitement thermique.

6. Procédé selon la revendication 5, caractérisé en ce que la réserve positive est appliquée sur le substrat en étant dissoute dans un solvant organique.

7. Procédé selon la revendication 6, caractérisé en ce qu'on utilise comme solvant la N-méthylpyrrolidone.

8. Procédé selon l'une quelconque des revendications 5 à 7, caractérisé en ce qu'on ajoute à la solution un agent adhésif et/ou mouillant.

9. Procédé selon une ou plusieurs des revendications 5 à 8, caractérisé en ce qu'on applique la solution sur le substrat au moyen de la technique de centrifugation.

10. Procédé selon une ou plusieurs des revendications 5 à 9, caractérisé en ce qu'on utilise un substrat en verre, en métal, en particulier en aluminium, en matière synthétique ou en une matière semi-conductrice.

11. Procédé selon l'une quelconque des revendications 5 à 10, caractérisé en ce que les structures à relief sont soumises à un traitement thermique à une température se situant entre 200 et 500°C, de préférence entre 300 et 400°C.
